# EUROPEAN PATENT SPECIFICATION

(11) **EP 2 878 632 B1**
(45) Date of publication and mention of the grant of the patent: **12.04.2017**
(21) Application number: 13822351.6
(22) Date of filing: 19.07.2013
(51) Int. Cl.: C08L 83/04, C08K 5/5415, C08K 5/56, C09D 7/12, C09D 183/04

(54) **ROOM-TEMPERATURE-CURABLE POLYORGANOSILOXANE COMPOSITION AND ELECTRIC/ELECTRONIC APPARATUS**
BEI RAUMTEMPERATUR HÄRTBARE POLYORGANOSILOXANZUSAMMENSETZUNG UND ELEKTRISCHE/ELEKTRONISCHE VORRICHTUNG
COMPOSITION DE POLYORGANOSILOXANE DURCISSABLE À LA TEMPÉRATURE AMBIANTE ET APPAREIL ÉLECTRIQUE/ÉLECTRONIQUE

(30) Priority: 27.07.2012 JP 2012167255
(43) Date of publication of application: 03.06.2015
(73) Proprietor: Momentive Performance Materials Japan LLC, Tokyo 107-6112 (JP)
(72) Inventor: IIDA Isao, Tokyo 107-6112 (JP); MORITA Yasuhito, Tokyo 107-6112 (JP)
(74) Representative: Granleese, Rhian Jane
(86) International application number: PCT/JP2013/069644
(87) International publication number: WO 2014/017397

(56) References cited:
- JP-A- 2004 536 920
- JP-A- 2007 106 946
- JP-A- 2010 084 063
- US-A1- 2007 282 047

## Description

### FIELD

The present invention relates to a room-temperature-curable polyorganosiloxane composition and an electric/electronic apparatus, and in particular, relates to a room-temperature-curable polyorganosiloxane composition forming a cured coating film excellent in scratch resistance and useful as a coating material and the like for an electric/electronic apparatus, and to an electric/electronic apparatus having the cured coating film of the room-temperature-curable polyorganosiloxane composition.

### BACKGROUND

Conventionally, various room-temperature-curable polyorganosiloxane compositions which cure at room temperature to produce a cured product in a rubber form or the like have been known. Among them, in the use as a coating material, a potting material, and the like of electric/electronic components, one of a type that undergoes a curing reaction by coming into contact with moisture in the air and emits alcohol, acetone, or the like which is little corroding metals at the time of the curing has been generally used because it has good workability, less likely corrode an electrode and a wiring, excellent adhesiveness and the like.

Especially as a conformal coating agent applied to protect surfaces of electric/electronic components and of a circuit board having these components mounted thereon from a use environment, there have been used a coating material made of a low-viscosity room-temperature-curable polyorganosiloxane composition (for example, refer to Patent Reference land Patent Reference 2) and a coating material of a type in which silicone resin is dissolved in a solvent.

However, a cured product (coating film) produced from the coating material made of the low-viscosity room-temperature-curable polyorganosiloxane composition is fragile and low in hardness and does not have sufficient scratch strength such as scratch resistance.
Further, in the coating material of the solvent type containing the silicone resin, the solvent needs to be removed by heating at the time of the curing, which is liable to worsen a work environment and corrode and deteriorate the electric/electronic components and the circuit board having these components mounted thereon due to the volatilization of the solvent. Further, if the solvent is tried to be recovered without being released in order to improve the work environment, a large amount of investment has been necessary.

Document US 2007/282047 which discloses in its example 3 a polysiloxane corresponding to present compound (A1) with a viscosity of 900 mPa.s, a hydrolyzate of methyltrimethoxysilane with a 20-mer as the main oligomer and titanium condensation catalyst.

### RELEVANT REFERENCES

### Patent References

Reference 1: JP-A H07-173435
Reference 2: JP-A H07-238259

### SUMMARY OF THE INVENTION

### PROBLEMS TO BE SOLVED BY THE INVENTION

The present invention was made in order to solve these conventional problems, and has an object to provide a room-temperature-curable polyorganosiloxane composition having low viscosity and good coatability without any solvent, and forming a cured coating film having high hardness and excellent scratch resistance.

### MEANS FOR SOLVING THE PROBLEMS

A room-temperature-curable polyorganosiloxane composition of the present invention contains:
(A) 100 parts by mass of polyorganosiloxane consisting of,
   (A1) 10 to 80 parts by mass of a polyorganosiloxane having the both molecular ends blocked with an alkoxysilyl group, which is expressed by a general formula (1), 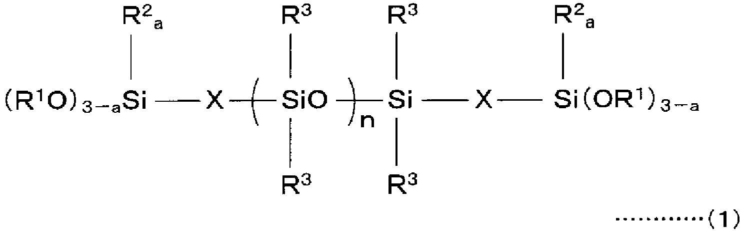 (In the formula, R¹ is an alkyl group or an alkoxy-substituted alkyl group being an alkyl group in which part of hydrogen atoms is substituted by an alkoxy group, R² and R³ are each an unsubstituted monovalent hydrocarbon group or a monovalent hydrocarbon group in which part of hydrogen atoms is substituted by a halogen atom or a cyano-alkyl group, and X is bivalent oxygen (oxy group) or a bivalent hydrocarbon group. Further, "a" is 0 or 1, and "n" is an integer expressed by 1 ≤ n < 20.), and
   (A2) 90 to 20 parts by mass of a partial hydrolysis condensate (the number of Si atoms in one molecule is 10 to 200) of a silane compound expressed by a general formula (2), R⁴_{b}Si(OR⁵)_{4-b} .... (2)
      (In the formula, R⁴ is an unsubstituted monovalent hydrocarbon group or a monovalent hydrocarbon group in which part of hydrogen atoms is substituted by a halogen atom or a cyano-alkyl group, R⁵ is an alkyl group or an alkoxy-substituted alkyl group being an alkyl group in which part of hydrogen atoms is substituted by an alkoxy group. Further, "b" is 0, 1, or 2 and an average value of "b" is 0.8 to 1.2.);
(B) 0.1 to 15 parts by mass of a silane compound expressed by a general formula (3) or a partial hydrolysis condensate (the number of Si atoms in one molecule is 1 or more and less than 10) of a silane compound,

   R⁶_{c}Si(OR⁷)_{4-c} ... (3)

   (In the formula, R⁶ is an unsubstituted monovalent hydrocarbon group or a monovalent hydrocarbon group in which part of hydrogen atoms is substituted by a halogen atom or a cyano-alkyl group, R⁷ is an alkyl group or an alkoxy-substituted alkyl group being an alkyl group in which part of hydrogen atoms is substituted by an alkoxy group, and "c" is 0, 1, or 2.); and
(C) 0.1 to 15 parts by mass of an organic titanium compound as a curing catalyst.

An electric/electronic apparatus of the present invention has, on a surface of an electrode and/or a wiring, a coating film made of a cured product of the above-described room-temperature-curable polyorganosiloxane composition of the present invention.

Note that, in the present description, an "alkoxysilyl group" refers to a group in which at least one alkoxy group is bonded to a silicon atom. Further, in the present description, a "dialkoxysilyl group" is also referred to as a bifunctional group or a bifunctional silyl group. Similarly, a "trialkoxysilyl group" is referred to as a trifunctional group or a trifunctional silyl group.

### EFFECT OF THE INVENTION

The room-temperature-curable polyorganosiloxane composition of the present invention has low viscosity and good coatability and can be applied as it is by an ordinary coating method without being diluted by a solvent. A coating film quickly cures at room temperature, and forms a cured coating film having high hardness (Type A) of 60 or more and excellent scratch resistance. Therefore, it is useful for the use as a coating material, a potting material, and the like of an electric/electronic apparatus, and is especially suitable for the use for coating electric/electronic components, such as a conformal coating agent..

### BRIEF DESCRIPTION OF THE DRAWINGS

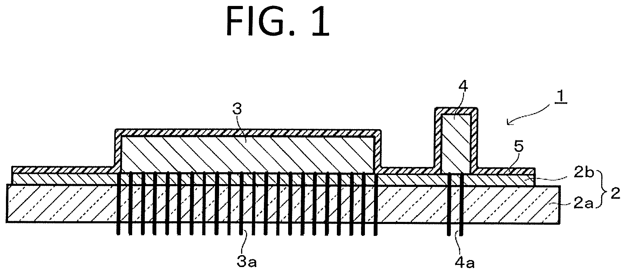

FIG. 1 is a cross-sectional view illustrating an example of an electric/electronic apparatus of the present invention.

### DETAILED DESCRIPTION

Hereinafter, an embodiment of the present invention will be described.
A room-temperature-curable polyorganosiloxane composition of the present invention contains:
(A) 100 parts by mass of polyorganosiloxane containing,
   (A1) a polyorganosiloxane having the both molecular ends blocked with an alkoxysilyl group (hereinafter, referred to as both ends alkoxysilyl group-terminated polyorganosiloxane), and (A2) a partial hydrolysis condensate (the number of Si atoms in one molecule is 10 to 200) of a silane compound, with predetermined ratio;
(B) 0.1 to 15 parts by mass of a silane compound or a partial hydrolysis condensate thereof (the number of Si atoms in one molecule is 1 or more and less than 10); and
(C) 0.1 to 15 parts by mass of an organic titanium compound as a curing catalyst.
The components will be hereinafter described.

In the embodiment of the present invention, the polyorganosiloxane being the component (A) is a base polymer of this composition, and consists of (A1) the both ends alkoxysilyl group-terminated polyorganosiloxane and (A2) the partial hydrolysis condensate (the number of Si atoms is 10 to 200) of the silane compound.

The both ends alkoxysilyl group-terminated polyorganosiloxane being the component (A1) is substantially linear polyorganosiloxane expressed by the following general formula (1).

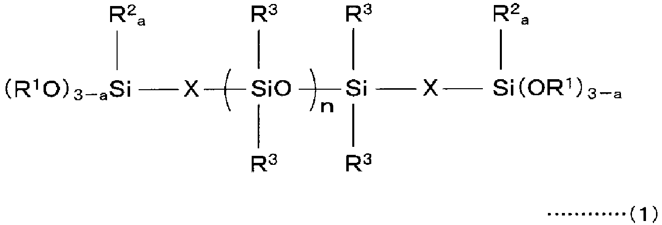

In the formula (1), R¹ is an alkyl group or an alkoxy-substituted alkyl group being an alkyl group in which part of hydrogen atoms is substituted by an alkoxy group. The plural R¹s may be the same or may be different. Concrete examples of the alkyl group being the aforesaid R¹ are a methyl group, an ethyl group, a propyl group, a butyl group, and the like, and concrete examples of the alkoxy-substituted alkyl group are a 2-methoxyethyl group, a 2-ethoxyethyl group, a 3-methoxypropyl group, and the like. R¹ is preferably a methyl group.

R² is an unsubstituted monovalent hydrocarbon group or a monovalent hydrocarbon group in which part of hydrogen atoms is substituted by a halogen atom or a cyano-alkyl group. The plural R²s may be the same or may be different. R³ is also an unsubstituted monovalent hydrocarbon group or a monovalent hydrocarbon group in which part of hydrogen atoms is substituted by a halogen atom or a cyano-alkyl group. The plural R³s may be the same or may be different.

Concrete examples of the unsubstituted monovalent hydrocarbon group being the aforesaid R² and R³ are: an alkyl group such as a methyl group, an ethyl group, a propyl group, a butyl group, a pentyl group, a hexyl group, an octyl group, a decyl group, and a dodecyl group; a cycloalkyl group such as a cyclohexyl group; an alkenyl group such as a vinyl group and an allyl group; an aryl group such as a phenyl group, a tolyl group, and a xylyl group; an aralkyl group such as a benzyl group, a 2-phenylethyl group, and a 2-phenylpropyl group; and so on. Examples of the substituted monovalent hydrocarbon group are a halogenated alkyl group being the aforesaid monovalent hydrocarbon group in which part of hydrogen atoms is substituted by a halogen atom, such as, for example, a chloromethyl group, a 3-chloropropyl group, and a 3,3,3-trifluoropropyl group, and, for example, a 3-cyano-propyl group being the aforesaid monovalent hydrocarbon group in which part of hydrogen atoms is substituted by a cyano-alkyl group. R² and R³ are each preferably a methyl group because it can be easily synthesized, has low viscosity as compared with its molecular weight, and gives a good physical property to a cured product (cured coating film). However, when it is necessary to impart heat resistance and cold resistance to the cured coating film, part of R²s and/or R³s is preferably an aryl group such as a phenyl group.

Further, X is bivalent oxygen (oxy group) or a bivalent hydrocarbon group. The two Xs may be the same or may be different. Examples of the bivalent hydrocarbon are an alkylene group such as a methylene group, an ethylene group, a propylene group, and a trimethylene group, and an arylene group such as a phenylene group. In view of easiness of synthesis, a bivalent oxygen atom (oxy group) or an ethylene group is preferable, and an oxy group is especially preferable.

In the formula (1), "a" is 0 or 1, and "n" is an integer expressed by 1 ≤ n < 20. When a value of "n" is 20 or more, compatibility with the later-described component (A2) is poor, and a uniform composition cannot be obtained. The value of "n" is preferably an integer within 3 to 15.

The both ends alkoxysilyl group-terminated polyorganosiloxane being the component (A1) can be obtained by, for example, causing methyltrimethoxysilane or the like to react with a both ends hydroxyl group containing diorganopolysiloxane which is obtained by subjecting cyclic diorganosiloxane oligomer such as octamethylsiloxane to ring-opening polymerization or ring-opening copolymerization under the presence of water with an acid catalyst or an alkaline catalyst, and blocking the hydroxyl groups at the both ends with methoxy groups or the like.

The component (A2) is the partial hydrolysis condensate of the silane compound expressed by a general formula (2): R⁴_{b}Si(OR⁵)_{4-b} .... (2).
In the formula (2), R⁴ is an unsubstituted monovalent hydrocarbon group or a monovalent hydrocarbon group in which part of hydrogen atoms is substituted by a halogen atom or a cyano-alkyl group, and examples thereof are the same groups as the aforesaid groups exemplified as R² of the aforesaid component (A1). A methyl group is preferable. Further, R⁵ is an alkyl group or an alkoxy-substituted alkyl group, and examples thereof are the same groups as the aforesaid groups exemplified as R¹ of the aforesaid component (A1). A methyl group is preferable. Further, "b" is 0,1, or 2, and an average value of "b" is 0.8 to 1.2. The average value of "b" is preferably 0.9 to 1.1.

In the silane compound expressed by the formula (2), the value of "b" represents the number (integer) of R⁴s bonded with silicone atoms. That the average value of this number "b" is 0.8 to 1.2 means that one kind or two kinds or more of silane compounds in which the value of "b" being the number of bonded R⁴s is 0, 1 or 2 is (are) compounded so that the average value of the values of "b" becomes 0.8 to 1.2 by the adjustment of molar ratios of the silane compounds.
For example, when the average value of "b" is within a range of 0.8 to 1.0, a compound in which "b" in the formula (2) is 0: Si(OR⁵)₄ and a compound in which "b" is 1: R⁴Si(OR⁵)₃ are compounded, and in a mixture of these two kinds of the silane compounds, a compounding ratio (molar ratio) of the compound in which "b" is 1: R⁴Si(OR⁵)₃ corresponds to the average value of "b".
Further, for example, when the average value of "b" is within a range of 1.0 to 1.2, a compound in which "b" in the formula (2) is 1: R⁴Si(OR⁵)₃ and a compound in which "b" is 2: R⁴₂Si(OR⁵)₂ are compounded, and in a mixture of these two kinds of the silane compounds, the sum of a compounding ratio (molar ratio) of the compound in which "b" is 2: R⁴₂Si(OR⁵)₂ and 1 corresponds to the average value of "b".

Thus, the silane compound which is a source of the partial hydrolysis condensate being the component (A2) contains one kind or two kinds or more of tetraalkoxysilane in which the value of "b" in the general formula (2) is 0, organotrialkoxysilane in which the value of "b" is 1, and organo-di-alkoxysilane in which the value of "b" is 2, and by adjusting their content ratios (molar ratios), the aforesaid average value of "b" is adjusted within the range of 0.8 to 1.2.

The component (A2) is the partial hydrolysis condensate of the aforesaid silane compound, and is obtained by, for example, partially hydrolyzing methyltrimethoxysilane or the like by an acid catalyst or an alkaline catalyst under the presence of water. Further, it is obtained by end-capping a silanol group produced by the partial hydrolysis by methyltrimethoxysilane or the like. In the component (A2), the number Si atoms in one molecule is 10 to 200. When the number of Si atoms in the component (A2) is less than 10, a cured coating film having sufficient scratch resistance cannot be obtained. Further, when the number of Si atoms in the component (A2) is over 200, coatability and a mechanical property of the cured coating film deteriorate. The number of Si atoms in the component (A2) is preferably 20 to 150.

As the partial hydrolysis condensate of the silane compound being the component (A2), one kind may be solely used, or the mixture of two kinds or more may be used.

The component (A) being the base polymer of the room-temperature-curable polyorganosiloxane composition of the present invention consists of (A1) the aforesaid both ends alkoxysilyl group-terminated polyorganosiloxane and (A2) the aforesaid partial hydrolysis condensate of the silane compound. As for compounding ratio of the component (A1) and the component (A2), when the total amount of the component (A) is defined as 100 parts by mass, the amount of the component (A1) is 10 to 80 parts by mass, and the amount of the component (A2) is 90 to 20 parts by mass. When the compounding amount of the component (A1) is less than 10 parts by mass and the compounding amount of the component (A2) is over 90 parts by mass, a composition that is usable as it is as a coating material without any solvent cannot be obtained. Further, when the compounding amount of the component (A1) is over 80 parts by mass and the compounding amount of the component (A2) is less than 20 parts by mass, a cured coating film having sufficient scratch resistance cannot be obtained. More preferably, the compounding ratio of the component (A1) and the component (A2) is 30 to 70 parts by mass for the component (A1) and 70 to 30 parts by mass for the component (A2).

In the embodiment of the present invention, the component (B) is the silane compound expressed by a general formula (3): R⁶_{c}Si(OR⁷)_{4-c} ... (3) or the partial hydrolysis condensate thereof, and works as a cross-linking agent of the base polymer being the aforesaid component (A).
In the formula (3), R⁶ is an unsubstituted monovalent hydrocarbon group or a monovalent hydrocarbon group in which part of hydrogen atoms is substituted by a halogen atom or a cyano-alkyl group, and examples thereof are the same groups as the aforesaid groups exemplified as R⁴ of the component (A2) and R² of the component (A1). A methyl group, a vinyl group, or the like is preferable. Further, R⁷ is an alkyl group or an alkoxy-substituted alkyl group, and examples thereof are the same groups as the aforesaid groups exemplified as R⁵ of the component (A2) and R¹ of the component (A1). A methyl group, an ethyl group, or the like is preferable. Further, "c" is 0, 1, or 2.

The number of Si atoms in one molecule of the silane compound or its partial hydrolysis condensate being the component (B) is 1 or more and less than 10. That is, the silane compound being the component (B) has one Si atom in one molecule, and its partial hydrolysis condensate has 2 to 9 Si atoms in one molecule.

Out of such components (B), examples of the silane compound are tetramethoxysilane, tetraethoxysilane, methyltrimethoxysilane, vinyltrimethoxysilane, phenyltrimethoxysilane, methyltriethoxysilane, vinyltriethoxysilane, phenyltriethoxysilane, tetrapropoxysilane, tetraisopropoxysilane, dimethyldimethoxysilane, diphenyldimethoxysilane, vinylmethyl dimethoxysilane, dimethyldiethoxysilane, and the like. Among these silane compounds or their partial hydrolysis condensates, one kind may be solely used or a mixture of two kinds or more may be used.

As the component (B) being the cross-linking agent, tetramethoxysilane, tetraethoxysilane, methyltrimethoxysilane, vinyltrimethoxysilane, dimethyldimethoxysilane, vinylmethyl dimethoxysilane, or dimethyldiethoxysilane is preferably used because they are easily synthesized, do not impair storage stability of the composition, little corrode metals, and enable to obtain a high cross-linking reaction speed, that is, a curing speed, and especially preferably, methyltrimethoxysilane is used.

A compounding amount of the component (B) to 100 parts by mass of the aforesaid component (A) is 0.1 to 15 parts by mass, and is preferably 0.5 to 10 parts by mass. When the compounding amount of the component (B) is less than 0.1 parts by mass, the cross linkage is not sufficiently performed and a cured product (cured coating film) having sufficient scratch resistance may not be obtained, and in addition, storage stability of the composition becomes poor. On the contrary, when the compounding amount of the component (B) is over 15 parts by mass, a shrinkage percentage at the time of the curing becomes large, and a physical property after the curing deteriorates. Further, the curing speed becomes very slow, which is economically disadvantageous.

In the room-temperature-curable polyorganosiloxane composition of the present invention, the organic titanium compound being the component (C) is a curing catalyst for forming a cross-linked structure by causing the alkoxy groups of the component (A) consisting of the component (A1) and the component (A2) to react with each other, and/or the alkoxy group of the component (A) and the alkoxy group of the cross-linking agent being the component (B) to react, under the presence of water.

Examples of (C) the organic titanium compound being the curing catalyst are tetraethoxytitanium, tetrapropoxytitanium, tetrabutoxytitanium, diisopropoxy-bis(ethyl acetoacetate) titanium, diisopropoxy-bis(methyl acetoacetate) titanium, diisopropoxy-bis(acetylacetone) titanium, dibutoxy-bis(ethyl acetoacetate) titanium, dimethoxy-bis(ethyl acetoacetate) titanium, and the like. Among these organic titanium compounds, one kind may be solely used or a mixture of two kinds or more may be used. Among all, titanium chelate such as diisopropoxy-bis(ethyl acetoacetate) titanium is especially preferable because it has large catalytic ability even with a minute amount and can produce a composition with little impurities.

Incidentally, in the room-temperature-curable polyorganosiloxane composition, as the curing catalyst for promoting the reaction between the alkoxy groups of the base component and/or the reaction of the alkoxy group of the base component and the alkoxy group of the cross-linking agent, an organic tin compound such as dibutyltin dioctoate or dibutyltin dilaurate is sometimes used, but when the organic tin compound is used as the curing catalyst with the component (A) and the component (B), it takes too long a time for the curing, which is not preferable. In the present invention, from a view point of both curability (curing speed) of the composition and scratch resistance of the cured coating film, the aforesaid organic titanium compound is used.

A compounding amount of the organic titanium compound being the component (C) to 100 parts by mass of the aforesaid component (A) is 0.1 to 15 parts by mass, and preferably 0.1 to 10 parts by mass. When the compounding amount is less than 0.1 parts by mass, it does not sufficiently function as the curing catalyst, and not only it takes a long time for the curing but also the curing especially in a deep portion distant from a contact surface with the air becomes insufficient. On the other hand, when the compounding amount is over 15 parts by mass, an effect worth the compounding amount is not obtained, which is not only meaningless but also uneconomical. Further, storage stability also deteriorates.

In the embodiment of the present invention, (D) a both ends alkoxysilyl group-terminated polyorganosiloxane expressed by the following general formula (4) can be further compounded for the purpose of adjusting coatability and a physical property after the curing.

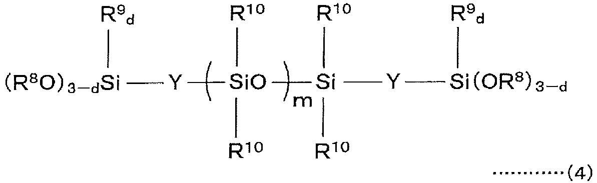

In the formula (4), R⁸ is an alkyl group or an alkoxy-substituted alkyl group. The plural R⁸s may be the same or may be different. Examples of R⁸ are the same groups as the aforesaid groups exemplified as R¹ of the component (A1). Preferable groups are also the same. R⁹ and R¹⁰ are each an unsubstituted monovalent hydrocarbon group or a monovalent hydrocarbon group in which part of hydrogen atoms is substituted by a halogen atom or a cyano-alkyl group. The plural R⁹s and the plural R¹⁰s may be the same or may be different. Examples of R⁹ are the same groups as the aforesaid groups exemplified as R² of the component (A1). Preferable groups are also the same. Further, examples of R¹⁰ are the same groups as the aforesaid groups exemplified as R³ of the component (A1). Preferable groups are also the same.

In the formula (4), Y is bivalent oxygen (oxy group) or a bivalent hydrocarbon group. The two Ys may be the same or may be different. Examples of Y are the same groups as the aforesaid groups exemplified as X of the component (A1). Preferable groups are also the same.
"d" is 0 or 1, and "m" is a positive number expressed by 20 ≤ m < 200. When a value of "m" is 200 or more, compatibility becomes poor and the component (D) separates, which is not preferable. The value of "m" is more preferably an integer within 20 to 100.

A compounding amount of the component (D) to 100 parts by mass of the aforesaid component (A) is preferably 1 to 100 parts by mass, and more preferably 10 to 80 parts by mass. When the compounding amount of the component (D) is over 100 parts by mass, part thereof separates from the composition during the storage, and scratch resistance after the curing deteriorates.

In the room-temperature-curable polyorganosiloxane composition of the present invention, as (E) an adhesion imparting agent, an isocyanurate compound such as tris(N-trialkoxysilylpropyl) isocyanurate is usable. Examples of the isocyanurate compound are 1,3,5-tris(N-trimethoxysilylpropyl) isocyanurate and the like.

In view of compatibility with the composition, a compounding amount of the adhesion imparting agent being the component (E) is preferably 0.01 to 5 parts by mass to 100 parts by mass of the component (A). When it is less than 0.01 parts by mass, the effect to improve adhesiveness is small or shows up slowly. When the compounding amount is over 5 parts by mass, not only the separation during the storage and the shrinkage of the cured product may occur but also storage stability and workability become worse, and a yellowing phenomenon may occur. The compounding amount is more preferably a range of 0.1 to 2 parts by mass.

Further, in the room-temperature-curable polyorganosiloxane composition of the present invention, various kinds of additives normally compounded in this type of composition, such as an inorganic filler, a pigment, a thixotropy imparting agent, a viscosity modifier for improving extrusion workability, an ultraviolet absorbent, a fungicide, a heat resistance improver, and a flame retardant, can be compounded as required within a range not obstructing the effects of the present invention. Examples of the inorganic filler are aerosol silica, baked silica, precipitated silica, aerosol titanium, and one obtained by hydrophobizing a surface of the above by organochlorosilanes, polyorganosiloxanes, hexamethyldisilazane, or the like. Besides, calcium carbonate, organic acid surface-treated calcium carbonate, diatomaceous earth, pulverized silica, aluminosilicate, magnesia, alumina, and the like are also usable. A compounding amount of the inorganic filler to 100 parts by mass of the component (A) is preferably 1 to 100 parts by mass, and more preferably 3 to 50 parts by mass.

The room-temperature-curable polyorganosiloxane composition of the present invention is obtained by mixing the aforesaid components (A) to (C) and the various components compounded as required in a moisture-free state. The obtained composition has 0.05 to 0.5 Pa·s viscosity at 23°C. Then, the composition can be used as what is called a single-package room-temperature-curable composition, that is, the composition is stored as it is in a hermetic vessel, and cures only after being exposed to moisture in the air when in use. Alternatively, the composition of the present invention can be used as what is called a multi-package room-temperature-curable composition, that is, for example, the cross-linking agent and the curing catalyst are separately prepared, stored separately in two to three different vessels as required, and mixed when in use. Note that the order in which the components are mixed is not particularly limited.

The room-temperature-curable polyorganosiloxane composition of the present invention has sufficiently low viscosity of 0.05 to 0.5 Pa·s at 23°C as described above, and thus has good coatability and can be applied as it is by an ordinary coating method without being diluted by a solvent. The coating film quickly cures at room temperature by coming into contact with the moisture in the air. The cured coating film has high hardness (Type A) of 60 or more and is excellent in electric and mechanical properties, especially in scratch resistance.

Therefore, the composition of the present invention is useful for the use as a coating material, a potting material, and the like of an electric/electronic apparatus, and is especially suitable for the use for protecting surfaces of electric/electronic components and of a circuit board having these components mounted thereon, such as a conformal coating agent. Concretely, it is suitably used as a coating material of, for example, an electrode, a wiring, and the like in an electric/electronic apparatus in which electric components such as a semiconductor device such as IC, a resistor, and a capacitor are mounted on a wiring board in which the electrode and the wiring made of ITO, copper, aluminum, silver, gold, or the like are formed on a substrate made of epoxy resin, phenol resin, polyimide resin, or the like or on a substrate made of ceramic such as alumina.

When the room-temperature-curable polyorganosiloxane composition of the present invention is used as a coating material of an electrode and/or a wiring of a wiring board, a dip method, a brush application method, a spray method, a dispense method, or the like is usable as a coating method, and a thickness of the coating layer is normally 0.01mm to 3 mm, and preferably 0.05mm to 2 mm. When the thickness is less than 0.01 mm, scratch resistance may not be sufficiently obtained. Further, when the thickness is over 3 mm, a higher effect is not obtained and in addition, it takes time for the interior to cure, which is uneconomical.

Next, an electric/electronic apparatus of the present invention will be described with reference to the drawing. FIG. 1 is a cross-sectional view illustrating an example of the electric/electronic apparatus (device) according to the present invention.
The electric/electronic apparatus 1 of the embodiment includes a wiring board 2 in which a wiring 2b made of a conductor such as a copper foil is formed on an insulating substrate 2a such as a glass epoxy substrate. Further, at predetermined positions of one main surface of such a wiring board 2, electric/electronic components such as an IC package 3 and a capacitor 4 are mounted and are electrically connected to the aforesaid wiring 2b. Incidentally, the IC package 3 and the capacitor 4 are connected to the wiring 2b by inserting lead terminals 3 a, 4a of these components to component holes (not illustrated) of the wiring board 2 and joining them via solder or the like.

Further, on the component mounting surface of the wiring board 2, a cured coating film 5 made of the cured product of the above-described room-temperature-curable polyorganosiloxane composition of the present invention is formed so as to cover upper surfaces of the IC package 3 and the capacitor 4.

In such an electric/electronic apparatus 1 of the embodiment, the wiring board 2 and the electric/electronic components mounted on the main surface of the wiring board 2 are covered by the cured coating film 5 excellent in scratch resistance and not likely to peel off or curl up by friction, and therefore, reliability is high.

### EXAMPLES

Hereinafter, examples of the present invention will be more concretely described, but these examples are not intended to limit the scope of the present invention. Note that, in the examples, "part" all represents "part by mass", and viscosity all indicates a value at 23 °C and at 50% relative humidity.

### Example 1

In 50 parts of (A1-1) polydimethylsiloxane having the both molecular ends blocked with methyldimethoxysilyl groups (viscosity; 0.013 Pa·s, the number of Si atoms in a molecule ; 10), 50 parts of (A2-1) partial hydrolysis condensate (the number of Si atoms ; 120) of a silane compound expressed by a formula: (CH₃)Si(OCH₃)₃, 5 parts of (B-1) methyltrimethoxysilane, 2 parts of (C-1) diisopropoxy-bis(ethyl acetoacetate) titanium, and 0.2 parts of (E) 1,3,5-tris(N-trimethoxysilylpropyl) isocyanurate were compounded, and they were uniformly mixed in a moisture-free state, whereby a polyorganosiloxane composition was obtained.

### Example 2

In 40 parts of (A1-1) polydimethylsiloxane having the both molecular ends blocked with methyldimethoxysilyl groups (viscosity; 0.013 Pa·s, the number of Si atoms in a molecule ; 10), 60 parts of (A2-2) partial hydrolysis condensate (the number of Si atoms ; 70) of a silane compound expressed by a formula: (CH₃)Si(OCH₃)₃, 30 parts of (D-1) polydimethylsiloxane having the both molecular ends blocked with methyldimethoxysilyl groups (viscosity; 0.09 Pa·s, the number of Si atoms in a molecule ; 80), 6 parts of (B-1) methyltrimethoxysilane, 2 parts of (C-1) diisopropoxy-bis(ethyl acetoacetate) titanium, and 0.2 parts of (E) 1,3,5-tris(N-trimethoxysilylpropyl) isocyanurate were compounded, and they were mixed as in the example 1, whereby a polyorganosiloxane composition was obtained.

### Example 3

In 60 parts of (A1-1) polydimethylsiloxane having the both molecular ends blocked with methyldimethoxysilyl groups (viscosity; 0.013 Pa·s, the number of Si atoms in a molecule ; 10), 40 parts of (A2-3) partial hydrolysis condensate (the number of Si atoms ; 30) of a silane compound expressed by a formula: (CH₃)Si(OCH₃)₃, 30 parts of (D-1) polydimethylsiloxane having the both molecular ends blocked with methyldimethoxysilyl groups (viscosity ; 0.09 Pa·s, the number of Si atoms in a molecule ; 80), 5 parts of (B-1) methyltrimethoxysilane, and 2 parts of (C-1) diisopropoxy-bis(ethyl acetoacetate) titanium were compounded, and they were mixed as in the example 1, whereby a polyorganosiloxane composition was obtained.

### Examples 4 to 6

The components presented in Table 1 were compounded with the respective compounding amounts presented in Table 1, and were mixed as in the example 1, whereby polyorganosiloxane compositions were obtained.

Note that, in Table 1, (A1-2) represents polydimethylsiloxane having the both molecular ends blocked with methyldimethoxysilyl groups (viscosity ; 0.017 Pa·s, the number of Si atoms in a molecule ; 15), (D-2) represents polydimethylsiloxane having the both molecular ends blocked with methyldimethoxysilyl groups (viscosity ; 0.07 Pa·s, the number of Si atoms in a molecule ; 60), (B-2) represents partial hydrolysis condensate (the number of Si atoms in a molecule ; 7) of methyltrimethoxysilane, and (C-2) represents dibutyltin dilaurate.

### Comparative Examples 1 to 4

The components presented in Table 2 were compounded with the respective compounding amounts presented in Table 2 and were mixed as in the example 1, whereby polyorganosiloxane compositions were obtained.

Note that, in Table 2, (D-3) represents polydimethylsiloxane having the both molecular ends blocked with methyldimethoxysilyl groups (viscosity; 0.7 Pa·s, the number of Si atoms in a molecule ; 300). Further, in the comparative example 4, (C-2) dibutyltin dilaurate was used as a curing catalyst.

Regarding the polyorganosiloxane compositions obtained in the examples 1 to 6 and the comparative example 1 to 4, various properties were measured and evaluated by the following methods. The results are presented in Table 1 for the examples 1 to 6, and in Table 2 for the comparative examples 1 to 4, together with the compositions.

### [Outer Appearance]

Outer appearances of the above-described polyorganosiloxane compositions were visually observed, and whether the components were uniformly mixed was examined.

### [Viscosity]

Viscosities of the above-described polyorganosiloxane compositions were measured based on JIS K6249. The measurement was conducted by using a rotational viscometer (manufactured by Shibaura Semteck Co., Ltd., product name: VISMETRON VDA-2) at a 30 rpm rotation speed and with a No. 2 rotor.

### [Tack-free Time]

Tack-free times of the above-described polyorganosiloxane compositions were measured based on JIS K6249. After the specimens were put flat on petri dishes made of aluminum foil (thickness of the specimens was 3 mm) while the entrance of bubbles was prevented, their surfaces were lightly touched by a fingertip washed by ethyl alcohol. The time taken for each of the specimens to cease adhering on the fingertip was set as the tack-free time.

### [Hardness]

Hardnesses of the above-described polyorganosiloxane compositions were measured as follows based on JIS K6249. Specifically, after the organosiloxane compositions were molded into a sheet shape with a 2 mm thickness, they were left to stand for three days at 23°C and 50% RH to be cured. Next, three pieces of the obtained cured sheets were stacked and the hardness was measured by a durometer (Type A).

### [Scratch Resistance]

The above-described polyorganosiloxane compositions were applied with a 100 µm thickness on comb-like electrode substrates having copper electrodes (pattern width; 0.316 mm) specified by JIS Z3197 (ISO9455), and were left to stand for three days at 23°C and 50% RH to be cured. Next, a pencil hardness test was conducted on formed cured coating films based on JIS K5600-5-4, and scratch resistance was evaluated. In the pencil hardness test, lines were drawn with a 750 g load by using 2B and 4B pencils, later states of the cured coating films were visually observed, and the evaluation was conducted according to the following criteria.

### <Evaluation Criteria>

evaluation A: The cured coating film did not curl up.
evaluation B: The cured coating film was broken. It curled up.

**[Table 1]**

| | | | Example 1 | Example 2 | Example 3 | Example 4 | Example 5 | Example 6 |
|---|---|---|---|---|---|---|---|---|
| composition (parts by mass) | (A1-1) both ends methyldimethoxysilyl group-terminated polydimethylsiloxane (number of Si atoms ;10) | | 50 | 40 | 60 | - | 30 | 30 |
| | (A1-2) both ends methyldimethoxysilyl group-terminated polydimethylsiloxane (number of Si atoms ;15) | | - | - | - | 30 | - | - |
| | (A2-1) partial hydrolysis condensate of (CH₃)Si(OCH₃)₃ (number of Si atoms; 120) | | 50 | - | - | - | 70 | 70 |
| | (A2-2) partial hydrolysis condensate of (CH₃)Si(OCH₃)₃ (number of Si atoms; 70) | | - | 60 | - | 70 | - | - |
| | (A2-3) partial hydrolysis condensate of (CH₃)Si(OCH₃)₃ (number of Si atoms; 30) | | - | - | 40 | - | - | - |
| | (D-1) both ends methyldimethoxysilyl group-terminated polydimethylsiloxane (number of Si atoms ; 80) | | - | 30 | 30 | - | - | - |
| | (D-2) both ends methyldimethoxysilyl group-terminated polydimethylsiloxane (number of Si atoms ; 60) | | - | - | - | 30 | 30 | 30 |
| | (D-3) both ends methyldimethoxysilyl group-terminated polydimethylsiloxane (number of Si atoms ; 300) | | - | - | - | - | - | - |
| | (B-1) methyltrimethoxysilane | | 5 | 6 | 5 | 5 | 5 | - |
| | (B-2) partial hydrolysis condensate of methyltrimethoxysilane (number of Si atoms; 7) | | - | - | - | - | - | 5 |
| | (C-1) diisopropoxy-bis(ethyl acetoacetate) titanium | | 2 | 2 | 2 | 2 | 2 | 2 |
| | (C-2) dibutyltin dilaurate | | - | - | - | - | - | - |
| | (E) 1,3,5-tris(N-trimethoxysilylpropyl) isocyanurate | | 0.2 | 0.2 | - | - | 0.2 | 0.2 |
| property evaluation | outer appearance | | uniform | uniform | uniform | uniform | uniform | uniform |
| | viscosity (mPa·s) | | 200 | 190 | 150 | 210 | 200 | 300 |
| | tack-free time (minute) | | 6 | 7 | 6 | 7 | 6 | 6 |
| | hardness | Type A | 85 | 80 | 69 | 84 | 80 | 80 |
| | scratch resistance | 2B | A | A | A | A | A | A |
| | | 4B | A | A | A | A | A | A |

**[Table 2]**

| | | | Comparative Example 1 | Comparative Example 2 | Comparative Example 3 | Comparative Example 4 |
|---|---|---|---|---|---|---|
| composition (parts by mass) | (A1-1) both ends methyldimethoxysilyl group-terminated polydimethylsiloxane (number of Si atoms ;10) | | - | 50 | - | 30 |
| | (A1-2) both ends methyldimethoxysilyl group-terminated polydimethylsiloxane (number of Si atoms ;15) | | - | - | - | - |
| | (A2-1) partial hydrolysis condensate of (CH₃)Si(OCH₃)₃ (number of Si atoms; 120) | | 50 | - | - | 70 |
| | (A2-2) partial hydrolysis condensate of (CH₃)Si(OCH₃)₃ (number of Si atoms; 70) | | - | - | - | - |
| | (A2-3) partial hydrolysis condensate of (CH₃)Si(OCH₃)₃ (number of Si atoms; 30) | | - | - | - | - |
| | (D-1) both ends methyldimethoxysilyl group terminated polydimethylsiloxane (number of Si atoms ; 80) | | - | 50 | - | - |
| | (D-2) both ends methyldimethoxysilyl group-terminated polydimethylsiloxane (number of Si atoms ; 60) | | - | - | - | 30 |
| | (D-3) both ends methyldimethoxysilyl group-terminated polydimethylsiloxane (number of Si atoms ; 300) | | 50 | - | 100 | - |
| | (B-1) methyltrimethoxysilane | | 5 | 5 | 5 | 5 |
| | (B-2) partial hydrolysis condensate of methyltrimethoxysilane (number of Si atoms; 7) | | - | - | - | - |
| | (C-1) diisopropoxy-bis(ethyl acetoacetate) titanium | | 2 | 2 | 2 | - |
| | (C-2) dibutyltin dilaurate | | - | - | - | 0.2 |
| | (E) 1,3,5-tris(N-trimethoxysilylpropyl) isocyanurate | | - | - | 0.2 | 0.2 |
| property evaluation | outer appearance | | uniform | uniform | uniform | uniform |
| | viscosity (mPa·s) | | 1000 | 20 | 500 | 310 |
| | tack-free time (minute) | | 6 | 5 | 6 | 300 |
| | hardness | Type A | 55 | fragile and cannot be measured | 27 | 80 |
| | scratch resistance | 2B | B | B | B | A |
| | | 4B | B | B | B | A |

It has been seen from Table 1 that the polyorganosiloxane compositions obtained in the examples 1 to 6 are uniform and have viscosity suitable for thin film coating, and in addition, form a cured coating film having high hardness (Type A) of 60 or more and excellent in scratch resistance.

On the other hand, as is seen from Table 2, in the comparative examples 1 and 2, a polyorganosiloxane composition that is uniform and has viscosity suitable as thin film coating was not obtained. Further, though the polyorganosiloxane composition obtained in the comparative example 3 has viscosity enabling the thin film coating, the obtained cured coating film is low in hardness and also poor in scratch resistance. Further, the polyorganosiloxane composition obtained in the comparative example 4 has a long tack-free time and it has been seen that it takes too long a time for the curing.

### INDUSTRIAL APPLICABILITY

The room-temperature-curable polyorganosiloxane composition of the present invention is useful for the use as a coating material, a potting material, and the like of an electric/electronic apparatus, and is especially suitable as a conformal coating agent in an electric/electronic apparatus in which electronic components and so on are mounted on a substrate.

## Claims

1. A room-temperature-curable polyorganosiloxane composition comprising:
(A) 100 parts by mass of polyorganosiloxane containing,
(A1) 10 to 80 parts by mass of a polyorganosiloxane having the both molecular ends blocked with an alkoxysilyl group, which is expressed by a general formula (1), 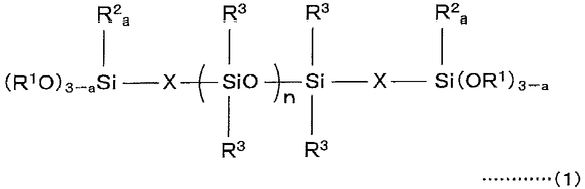 where R¹ is an alkyl group or an alkoxy-substituted alkyl group being an alkyl group in which part of hydrogen atoms is substituted by an alkoxy group, R² and R³ are each an unsubstituted monovalent hydrocarbon group or a monovalent hydrocarbon group in which part of hydrogen atoms is substituted by a halogen atom or a cyano-alkyl group, X is bivalent oxygen, i.e. an oxy group,
or a bivalent hydrocarbon group, "a" is 0 or 1, and "n" is an integer expressed by 1 ≤ n < 20, and
(A2) 90 to 20 parts by mass of a partial hydrolysis condensate (the number of Si atoms in one molecule is 10 to 200) of a silane compound expressed by a general formula (2),
R⁴_{b}Si(OR⁵)_{4-b} .... (2)
where R⁴ is an unsubstituted monovalent hydrocarbon group or a monovalent hydrocarbon group in which part of hydrogen atoms is substituted by a halogen atom or a cyano-alkyl group, R⁵ is an alkyl group or an alkoxy-substituted alkyl group being an alkyl group in which part of hydrogen atoms is substituted by an alkoxy group, "b"is 0, 1, or 2 and an average value of "b" is 0.8 to 1.2;
(B) 0.1 to 15 parts by mass of a silane compound expressed by a general formula (3) or a partial hydrolysis condensate (the number of Si atoms in one molecule is 1 or more and less than 10) of the silane compound,
R⁶_{c}Si(OR⁷)_{4-c} ... (3)
where R⁶ is an unsubstituted monovalent hydrocarbon group or a monovalent hydrocarbon group in which part of hydrogen atoms is substituted by a halogen atom or a cyano-alkyl group, R⁷ is an alkyl group or an alkoxy-substituted alkyl group being an alkyl group in which part of hydrogen atoms is substituted by an alkoxy group, and "c" is 0, 1, or 2; and
(C) 0.1 to 15 parts by mass of an organic titanium compound as a curing catalyst.

2. The room-temperature-curable polyorganosiloxane composition according to claim 1, further comprising
(D) 1 to 100 parts by mass of a polyorganosiloxane having the both molecular ends blocked with an alkoxysilyl group, which is expressed by a general formula (4), 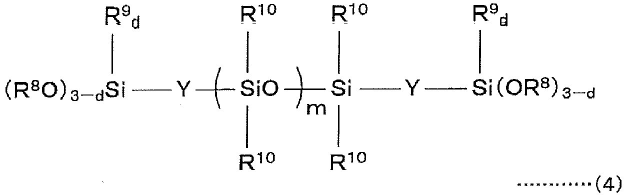 where R⁸ is an alkyl group or an alkoxy-substituted alkyl group being an alkyl group in which part of hydrogen atoms is substituted by an alkoxy group, R⁹ and R¹⁰ are each an unsubstituted monovalent hydrocarbon group or a monovalent hydrocarbon group in which part of hydrogen atoms is substituted by a halogen atom or a cyano-alkyl group, Y is bivalent oxygen or a bivalent hydrocarbon group, "d" is 0 or 1, and "m" is an integer expressed by 20 ≤ m < 200.

3. The room-temperature-curable polyorganosiloxane composition according to claim 1 or 2, being a composition for coating an electrode and/or a wiring of an electric/electronic apparatus.

4. An electric/electronic apparatus comprising a coating film made of a cured product of the room-temperature-curable polyorganosiloxane composition according to any one of claims 1 to 3, on a surface of an electrode and/or a wiring.

## Patentansprüche

1. Bei Raumtemperatur härtbare Polyorganosiloxanzusammensetzung, umfassend:
(a) 100 Masseteile Polyorganosiloxanzusammensetzung enthaltend
(A1) 10 bis 80 Masseteile eines Polyorganosiloxans, bei dem beide molekulare Enden mit einer Alkoxysilylgruppe blockiert sind und das durch eine allgemeine Formel (1) ausgedrückt ist 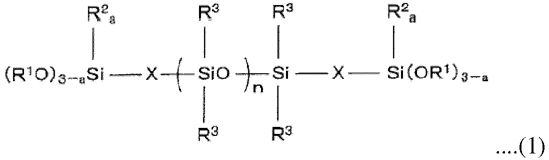 wobei R¹ eine Alkylgruppe oder eine alkoxysubstituierte Alkylgruppe ist, die eine Alkylgruppe ist, in der ein Teil der Wasserstoffatome durch eine Alkoxygruppe substituiert ist, R² und R³ jeweils eine unsubstituierte einwertige Kohlenwasserstoffgruppe oder eine einwertige Kohlenwasserstoffgruppe sind, in der ein Teil der Wasserstoffatome durch ein Halogenatom oder eine Cyanoalkylgruppe substituiert ist, X ein zweiwertiger Sauerstoff, d.h. eine Oxygruppe, oder eine zweiwertige Kohlenwasserstoffgruppe ist, "a" 0 oder 1 beträgt und "n" eine ganze Zahl ist, die durch 1≤n<20 ausgedrückt ist, und
(A2) 90 bis 20 Masseteile eines teilweisen Hydrolysekondensats (die Anzahl von Si-Atomen in einem Molekül beträgt 10 bis 200) einer Silanverbindung, die durch die allgemeine Formel (2) ausgedrückt ist,
R⁴₆Si(OR⁵)_{4-b} .... (2)
wobei R⁴ eine unsubstituierte einwertige Kohlenwasserstoffgruppe oder eine einwertige Kohlenwasserstoffgruppe ist, in der ein Teil der Wasserstoffatome durch ein Halogenatom oder eine Cyanoalkylgruppe substituiert ist, R⁵ eine Alkylgruppe oder eine alkoxysubstituierte Alkylgruppe ist, die eine Alkylgruppe ist, in der ein Teil der Wasserstoffatome durch eine Alkoxygruppe substituiert ist, "b" 0, 1 oder 2 beträgt und ein Durchschnittswert von "b" 0,8 bis 1,2 beträgt;
(B) 0,1 bis 15 Masseteile einer Silanverbindung, die durch eine allgemeine Formel (3) ausgedrückt ist, oder eines teilweisen Hydrolysekondensats (die Anzahl von Si-Atomen in einem Molekül beträgt 1 oder mehr und weniger als 10) der Silanverbindung,
R⁶_{c}Si(OR⁷)_{4-c} .... (3)
wobei R⁶ eine unsubstituierte einwertige Kohlenwasserstoffgruppe oder eine einwertige Kohlenwasserstoffgruppe ist, in der ein Teil der Wasserstoffatome durch ein Halogenatom oder eine Cyanoalkylgruppe substituiert ist, R⁷ eine Alkylgruppe oder eine alkoxysubstituierte Alkylgruppe ist, die eine Alkylgruppe ist, in der ein Teil der Wasserstoffatome durch eine Alkoxygruppe substituiert ist, und "c" 0, 1 oder 2 beträgt; und
(C) 0,1 bis 15 Masseteile einer organischen Titanverbindung als Härtungskatalysator.

2. Bei Raumtemperatur härtbare Polyorganosiloxanzusammensetzung nach Anspruch 1, ferner Folgendes umfassend
(D) 1 bis 100 Masseteile eines Polyorganosiloxans, bei dem beide molekulare Enden mit einer Alkoxysilylgruppe blockiert sind und das durch eine allgemeine Formel (4) ausgedrückt ist 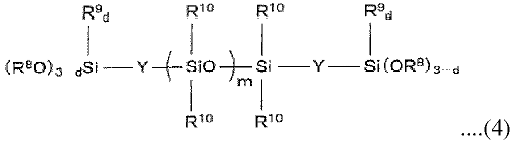 wobei R⁸ eine Alkylgruppe oder eine alkoxysubstituierte Alkylgruppe ist, die eine Alkylgruppe ist, in der ein Teil der Wasserstoffatome durch eine Alkoxygruppe substituiert ist, R⁹ und R¹⁰ jeweils eine unsubstituierte einwertige Kohlenwasserstoffgruppe oder eine einwertige Kohlenwasserstoffgruppe sind, in der ein Teil der Wasserstoffatome durch ein Halogenatom oder eine Cyanoalkylgruppe substituiert ist, Y ein zweiwertiger Sauerstoff oder eine zweiwertige Kohlenwasserstoffgruppe ist, "d" 0 oder 1 beträgt und "m" eine ganze Zahl ist, die durch 20≤m<200 ausgedrückt ist.

3. Bei Raumtemperatur härtbare Polyorganosiloxanzusammensetzung nach Anspruch 1 oder 2, die eine Zusammensetzung zum Beschichten einer Elektrode und/oder einer Verkabelung einer elektrischen/elektronischen Vorrichtung ist.

4. Elektrische/elektronische Vorrichtung umfassend einen Beschichtungsfilm, der aus einem gehärteten Produkt der bei Raumtemperatur härtbaren Polyorganosiloxanzusammensetzung nach einem der Ansprüche 1 bis 3 auf einer Oberfläche einer Elektrode und/oder einer Verkabelung hergestellt wird.

## Revendications

1. Composition de polyorganosiloxane durcissable à la température ambiante comprenant:
(A) 100 parties en masse d'un polyorganosiloxane contenant,
(A1) de 10 à 80 parties en masse d'un polyorganosiloxane ayant les deux extrémités moléculaires bloquées avec un groupe alcoxysilyle, qui est exprimé par une formule générale (1), 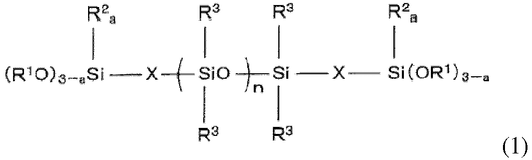 où R¹ est un groupe alkyle ou un groupe alkyle substitué par un groupe alcoxy qui est un groupe alkyle dans lequel une partie des atomes d'hydrogène est substituée par un groupe alcoxy, R² et R³ sont chacun un groupe hydrocarbure monovalent non substitué ou un groupe hydrocarbure monovalent dans lequel une partie des atomes d'hydrogène est substituée par un atome d'halogène ou un groupe cyano-alkyle, X est un atome d'oxygène bivalent, c'est-à-dire un groupe oxy, ou un groupe hydrocarbure bivalent, « a » a la valeur de 0 ou 1, et « n » est un nombre entier exprimé par 1 ≤ n < 20, et
(A2) de 90 à 20 parties en masse d'un condensé d'hydrolyse partielle (le nombre d'atomes de Si dans une molécule est de 10 à 200) d'un composé silane exprimé par une formule générale (2),
R⁴₆Si(OR⁵)_{4-b} .... (2)
où R⁴ est un groupe hydrocarbure monovalent non substitué ou un groupe hydrocarbure monovalent dans lequel une partie des atomes d'hydrogène est substituée par un atome d'halogène ou un groupe cyano-alkyle, R⁵ est un groupe alkyle ou un groupe alkyle substitué par un groupe alcoxy qui est un groupe alkyle dans lequel une partie des atomes d'hydrogène est substituée par un groupe alcoxy, « b » a la valeur de 0, 1, ou 2 et une valeur moyenne de « b » est de 0,8 à 1,2;
(B) de 0,1 à 15 parties en masse d'un composé silane exprimé par une formule générale (3) ou un condensé d'hydrolyse partielle (le nombre d'atomes de Si dans une molécule est de 1 ou plus et inférieur à 10) du composé silane,
R⁶_{c}Si(OR⁷)_{4-c} ... (3)
où R⁶ est un groupe hydrocarbure monovalent non substitué ou un groupe hydrocarbure monovalent dans lequel une partie des atomes d'hydrogène est substituée par un atome d'halogène ou un groupe cyano-alkyle, R⁷ est un groupe alkyle ou un groupe alkyle substitué par un groupe alcoxy qui est un groupe alkyle dans lequel une partie des atomes d'hydrogène est substituée par un groupe alcoxy, et « c » a la valeur de 0, 1, ou 2; et
(C) de 0,1 à 15 parties en masse d'un composé de titane organique comme catalyseur de durcissement.

2. Composition de polyorganosiloxane durcissable à la température ambiante selon la revendication 1, comprenant en outre
(D) de 1 à 100 parties en masse d'un polyorganosiloxane ayant les deux extrémités moléculaires bloquées avec un groupe alcoxysilyle, qui est exprimé par une formule générale (4), 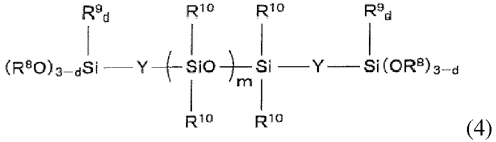 où R⁸ est un groupe alkyle ou un groupe alkyle substitué par un groupe alcoxy qui est un groupe alkyle dans lequel une partie des atomes d'hydrogène est substituée par un groupe alcoxy, R⁹ et R¹⁰ sont chacun un groupe hydrocarbure monovalent non substitué ou un groupe hydrocarbure monovalent dans lequel une partie des atomes d'hydrogène est substituée par un atome d'halogène ou un groupe cyano-alkyle, Y est un atome d'oxygène bivalent ou un groupe hydrocarbure bivalent, « d » a la valeur de 0 ou 1, et « m » est un nombre entier exprimé par 20 ≤ m < 200.

3. Composition de polyorganosiloxane durcissable à la température ambiante selon la revendication 1 ou 2, qui est une composition destinée à l'enduction d'une électrode et/ou d'un câblage d'un appareil électrique/électronique.

4. Appareil électrique/électronique comprenant un film d'enduction fabriqué à partir d'un produit durci de la composition de polyorganosiloxane durcissable à la température ambiante selon l'une quelconque des revendications 1 à 3, sur une surface d'une électrode et/ou d'un câblage.
